# EUROPÄISCHE PATENTSCHRIFT

(11) **EP 0 796 505 B1**
(45) Veröffentlichungstag und Bekanntmachung des Hinweises auf die Patenterteilung: **09.09.1998**
(21) Anmeldenummer: 95940142.3
(22) Anmeldetag: 05.12.1995
(51) Int. Cl.: H01J 37/32

(54) **PLASMAREAKTOR UND VERFAHREN ZU DESSEN BETRIEB**
PLASMA REACTOR AND METHOD OF OPERATING THE SAME
REACTEUR AU PLASMA ET PROCEDE PERMETTANT DE LE FAIRE FONCTIONNER

(30) Priorität: 07.12.1994 DE 4443608
(43) Veröffentlichungstag der Anmeldung: 24.09.1997
(73) Patentinhaber: SIEMENS AKTIENGESELLSCHAFT, 80333 München (DE)
(72) Erfinder: WERNER, Christoph, D-84665 Moosach (DE); BRINKMANN, Ralf, Peter, D-81379 München (DE)
(86) Internationale Anmeldenummer: DE9501739
(87) Internationale Veröffentlichungsnummer: WO9618207

(56) Entgegenhaltungen:
- EP-A- 0 334 109
- EP-A- 0 651 427
- FR-A- 2 636 079
- US-A- 5 162 633

## Beschreibung

Bei der Herstellung integrierter Schaltungen, insbesondere bei der Siliziumprozeßtechnik, werden vielfach Plasmareaktoren eingesetzt. In den Plasmareaktoren wird ein Niederdruckplasma erzeugt, in dem reaktive Ionen vorhanden sind, die an der Oberfläche eines im Reaktor befindlichen Substrates eine Atzreaktion oder eine Abscheidereaktion auslösen. Im Plasmareaktor werden sowohl Ätzprozesse als auch Schichtabscheidungen von Isolatoren, Metallschichten, Halbleiterschichten und ähnlichem durchgeführt.

Das Plasma wird in verschiedenen Plasmareaktoren unterschiedlich angeregt. In dem sogenannten Parallelplattenreaktor, wie er zum Beispiel in W. Böhme et al, IEEE Transactions on Plasma Science, Vol. 22, Seiten 110 bis 115, beschrieben ist, wird das Plasma zwischen zwei Elektroden angeregt, von denen eine geerdet, die andere kapazitiv mit Hochfrequenzspannung verbunden ist. Das zu prozessierende Substrat wird im Parallelplattenreaktor auf der geerdeten Elektrode angeordnet.

Aus P. Singer, Semiconductor international, July 1992, Seite 52 bis 57, ist ein Plasmareaktor bekannt, der in der Fachwelt als ICP-Reaktor bezeichnet wird. Im ICP-Reaktor wird ein Plasma durch induktive Einkopplung elektrischer Energie gezündet. Dazu umfaßt der ICP-Reaktor einen Scheibenhalter zur Aufnahme des zu prozessierenden Substrates, der zum Beispiel geerdet ist. Gegenüber des Scheibenhalters ist eine Antenne angeordnet, die gegenüber der Innenwand des ICP-Reaktors zum Beispiel durch eine isolierende Schicht isoliert ist. Über die Antenne wird induktiv ein Hochfrequenzfeld in den Reaktor eingekoppelt.

Aus FR-A-2 636 079 ist ein Plasmareaktor bekannt, der mehrere von einander unabhängig ansteuerbare Teileinrichtungen aufweist.

Beim Plasmaätzen sowie bei der plasmaunterstützten Schichtabscheidung werden häufig Inhomogenitäten in den Ätz- bzw. Abscheideraten zwischen der Mitte und dem Rand des Reaktors beobachtet. Bei der Prozessierung von Substratscheiben mit großem Durchmesser wirken sich diese Inhomogenitäten bei der Schichterzeugung und Schichtstrukturierung besonders störend aus. Dieses ist besonders gravierend bei Siliziumscheiben mit einem Durchmesser von 8" oder mehr, wie sie bei der Herstellung von Schaltungsstrukturen in der 0,35 µm und 0,25 µm-Generation vorgesehen werden.

Zur Vermeidung der Inhomogenität in Ätzraten ist vorgeschlagen worden (siehe zum Beispiel S. Butler et al, Proc. of the American Control Conf., 1993, Seiten 3003 bis 3007), ein Prozeßgas zu wählen, bei dem der Ätzprozeß mit hoher Selektivität zur Unterlage der zu strukturierenden Schicht abläuft. Die Unterlage wird durch den Ätzprozeß aufgrund der Selektivität nicht oder kaum angegriffen. Daher kann die Ätzdauer so gewählt werden, daß die zu strukturierende Schicht auch in denjenigen Bereichen des Reaktors, in denen die Ätzrate aufgrund der Inhomogenität am geringsten ist, sicher durchätzt wird. Da Ätzprozesse mit hoher Selektivität bezüglich der Ätzrate und der Anisotropie der Ätzung oft unbefriedigend sind, ist vorgeschlagen worden, mehrstufige Ätzprozesse zu verwenden. Durch Abstimmung der einzelnen Ätzprozesse wird in der Kombination ein Optimum an Selektivität, Ätzrate und Anisotropie erzielt.

Der Erfindung liegt die Aufgabe zugrunde, einen Plasmareaktor anzugeben, in dem die Homogenität der Prozeßrate über den Durchmesser des Plasmareaktors gegenüber dem Stand der Technik verbessert ist. Weiterhin ist es Aufgabe der Erfindung, ein Betriebsverfahren für einen derartigen Plasmareaktor anzugeben.

Diese Aufgabe wird erfindungsgemäß gelöst durch einen Plasmareaktor gemäß Anspruch 1 oder 3 sowie ein Verfahren zu dessen Betrieb gemäß Anspruch 5. Weitere Ausgestaltungen der Erfindung gehen aus den Unteransprüchen hervor.

In dem erfindungsgemäßen Plasmareaktor wird das Plasma an verschiedenen Positionen oberhalb eines zu prozessierenden Substrates unterschiedlich angeregt. Dadurch können Inhomogenitäten der Prozeßraten, die einerseits auf eine Inhomogenität des Plasmas selbst und andererseits auf einen inhomogenen Verbrauch der reaktiven Gasmoleküle zurückgeführt werden, ausgeglichen werden.

Der Plasmareaktor umfaßt dazu eine Einrichtung zur Plasmaanregung durch Einkopplung elektrischer Energie, die mindestens zwei unabhängig voneinander ansteuerbare Teileinrichtungen umfaßt. Gemäß einer Ausführungsform umfaßt die Einrichtung zur Plasmaanregung mindestens eine mit einem Bezugspotential verbundene Elektrode und eine Gegenelektrodenanordnung. Die Gegenelektrodenanordnung weist dabei mindestens zwei oder mehr voneinander unabhängig ansteuerbare Gegenelektrodenelemente auf. Ferner umfaßt die Einrichtung zur Plasmaanregung zu jedem Gegenelektrodenelement eine Hochfrequenzspannungsquelle, die mit dem jeweiligen Gegenelektrodenelement kapazitiv verbunden ist. Zwischen der mit Bezugspotential verbundenen Elektrode und jedem Gegenelektrodenelement erfolgt die Anregung eines Plasmas. Jedes Gegenelektrodenelement, die zugeordnete Hochfrequenzspannungsquelle sowie die mit Bezugspotential verbundene Elektrode bildet eine Teileinrichtung zur Plasmaanregung.

Der Scheibenhalter zur Aufnahme des zu prozessierenden Substrats ist in dieser Ausführungsform zwischen der mit Bezugspotential verbundenen Elektrode und der Gegenelektrodenanordnung angeordnet. Der Scheibenhalter kann sowohl auf der mit Bezugspotential verbundenen Elektrode als auch auf einem der Gegenelektrodenelemente angeordnet sein.

Da in der Siliziumprozeßtechnik meist scheibenförmige Substrate verwendet werden, ist es vorteilhaft, eines der Gegenelektrodenelemente kreisförmig auszubilden und das oder die weiteren Gegenelektrodenelemente ringförmig auszubilden. Das kreisförmige Gegenelektrodenelement und das oder die ringförmigen Gegenelektrodenelemente werden konzentrisch in einer Ebene angeordnet. Durch diese kreis-/ringförmigen Gegenelektrodenelemente werden Inhomogenitäten in einer Zylindergeometrie, wie sie bei der Verwendung von scheibenförmigen Substraten vorliegt, optimal ausgeglichen.

Weist der Plasmareaktor und/oder das zu prozessierende Substrat eine andere Symmetrie auf, so liegt es im Rahmen der Erfindung, die Gegenelektrodenelemente mit anderer Geometrie, zum Beispiel als Sektoren eines Kreises, vorzusehen.

Gemäß einer weiteren Ausführungsform umfaßt der Plasmareaktor als Einrichtung zur Plasmaanregung eine Antennenanordnung mit zwei oder mehr Antennen, über die die Plasmaanregung induktiv erfolgt. Zu jeder Antenne ist eine mit dieser verbundene Wechselstromquelle vorgesehen. Antenne und Wechselstromquelle bilden jeweils eine Teileinrichtung. Der Plasmareaktor entspricht in dieser Ausführungsform dem als ICP-Reaktor bekannten Typ.

Zum Ausgleich von Inhomogenitäten bei Zylindersymmetrie ist es in diesem Fall vorteilhaft, die Antennen jeweils im wesentlichen ringförmig mit unterschiedlichem Radius auszubilden und konzentrisch in einer Ebene anzuordnen.

Die Ansteuerung der Teileinrichtungen zur Plasmaanregung erfolgt auf einfachste Weise durch Bestimmung der Parameter für die einzelnen Teileinrichtungen über Eichmessungen. Dazu werden Versuchsreihen mit verschiedenen Parametereinstellung für die Ansteuerung der Teileinrichtungen durchgeführt.

Es liegt im Rahmen der Erfindung, die Ansteuerung der Teileinrichtungen zur Plasmaanregung in situ zu optimieren. Dazu sind im Plasmareaktor Mittel vorgesehen, mit denen eine Messung einer dem Prozeß unterworfenen Größe an mehreren Orten eines auf dem Scheibenhalter angeordneten Substrates vorgesehen sind. In Abhängigkeit der Messung werden über eine Steuereinheit die Teileinrichtungen angesteuert. Zur Messung der Prozeßgröße ist zum Beispiel ein Ellipsometer geeignet. Im Fall einer Schichtabscheidung können auch an mehreren Orten vorgesehene Schwingquarze, wie sie bei der Schichtabscheidung zur Dickenkontrolle verwendet werden, eingesetzt werden.

Schließlich liegt es im Rahmen der Erfindung, durch Vergleich der gemessenen Größe an verschiedenen Orten des Substrates mit dem entsprechenden Wert einer numerischen Simulation des Plasmareaktors iterativ optimale Parameter zur Ansteuerung der Teileinrichtungen zur Plasmaanregung zu bestimmen und mit diesen den Prozeß durchzuführen.

Im folgenden wird die Erfindung anhand der Figuren und der Ausführungsbeispiele näher erläutert.
- Figur 1: zeigt einen Plasmareaktor mit zwei Gegenelektrodenelementen.
- Figur 2: zeigt die Abscheiderate in dem in Figur 1 dargestellten Plasmareaktor für eine feste Spannung an dem einen und eine variable Spannung an dem anderen Gegenelektrodenelement.
- Figur 3: zeigt die Abscheiderate in dem in Figur 1 gezeigten Plasmareaktor für eine variable Spannung an dem einen und eine feste Spannung an dem anderen Gegenelektrodenelement.
- Figur 4: zeigt einen Parallelplattenreaktor mit drei Gegenelektrodenelementen und mit Mitteln zur Messung einer dem Prozeß unterworfenen Größe und Mitteln zur Regelung der Ansteuerung der Gegenelektrodenelemente.
- Figur 5: zeigt einen ICP-Reaktor mit drei Antennen.

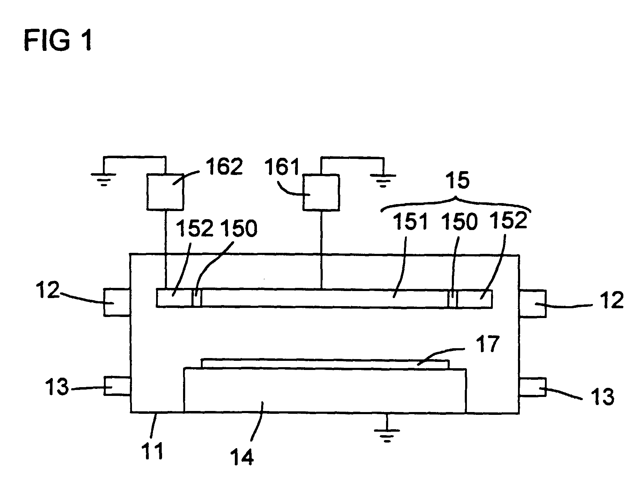

Ein Plasmareaktor umfaßt eine Reaktionskammer 11, die Pumpstutzen 12 sowie Gaszuführungen 13 für die Zuleitung von Prozeßgas aufweist (siehe Figur 1). Die Reaktionskammer 11 ist mit einem Bezugspotential, zum Beispiel Erdpotential verbunden.

In der Reaktionskammer 11 ist ein Scheibenhalter 14 vorgesehen, der ebenfalls auf dem Bezugspotential liegt. Der Scheibenhalter 14 ist zum Beispiel zylinderförmig und weist einen Durchmesser von 200 mm auf. In dem Plasmareaktor bildet der Scheibenhalter 14 eine auf Bezugspotential liegende Elektrode.

Dem Scheibenhalter 14 gegenüber ist eine Gegenelektrodenanordnung 15 vorgesehen. Die Gegenelektrodenanordnung 15 umfaßt ein erstes Gegenelektrodenelement 151 und ein zweites Gegenelektrodenelement 152. Das erste Gegenelektrodenelement 151 ist kreisförmig mit einem Durchmesser von zum Beispiel 200 mm. Das zweite Gegenelektrodenelement 152 ist ringförmig, wobei die Breite des Rings zum Beispiel 30 mm beträgt. Das zweite Gegenelektrodenelement 152 ist konzentrisch mit dem ersten Gegenelektrodenelement 151 in einer Ebene angeordnet. Zwischen dem ersten Gegenelektrodenelement 151 und dem zweiten Gegenelektrodenelement 152 ist ein Spalt 150 in einer Breite von zum Beispiel 1 mm. Der Abstand zwischen der Gegenelektrodenanordnung 15 und dem Scheibenhalter 14 beträgt zum Beispiel 41 mm.

Jedes der Gegenelektrodenelemente 151, 152 ist kapazitiv mit jeweils einer Hochfrequenz-Spannungsquelle 161, 162 verbunden. Die Hochfrequenzspannungsquellen 161, 162 sind unabhängig voneinander regelbar. Insbesondere können am ersten Gegenelektrodenelement 151 und am zweiten Gegenelektrodenelement 152 unabhängig voneinander die Amplitude oder die Phase der Elektrodenansteuerung variiert werden. Ferner sind unabhängige Variationen der Ansteuerfrequenz oder des eingepragten Gleichstromanteils möglich.

In diesem Plasmareaktor ist die Homogenität des durchgeführten Prozesses über den Durchmesser einer auf dem Scheibenhalter 14 angeordneten Substratscheibe 17 durch unabhängige Ansteuerung des ersten Gegenelektrodenelementes 151 und des zweiten Gegenelektrodenelementes 152 einstellbar.

Die optimierten Parameter werden zum Beispiel durch vorab durchgeführte Versuchsreihen ermittelt. Dabei wird die Homogenität des Prozesses über versuchsweise prozessierte Scheiben in Abhängigkeit der an die Gegenelektrodenelemente 151, 152 angelegten Parameter ermittelt.

Bei dieser Parameterbestimmung ist es vorteilhaft, die gemessenen Daten mit dem Ergebnis von Simulationsrechnungen zu vergleichen. Ist für den Plasmareaktor eine Modellbeschreibung mit Hilfe einer analytischen Fitfunktion möglich, so kann die optimale Elektrodenansteuerung mit Hilfe einfacher Formeln und einer Anzahl empirisch angepaßter Parameter bestimmt werden. Ferner ist ein iteratives Vorgehen zur Bestimmung der optimierten Prozeßparameter möglich.

Der anhand von Figur 1 erläuterte Plasmareaktor ist zum Beispiel zur Abscheidung von amorphem Silizium geeignet. In diesem Fall wird als Prozeßgas SiH₄ mit einer Durchflußrate von 50 sccm verwendet. In der Reaktorkammer wird ein Druck p von 20 Pa eingestellt. Die Temperatur im Reaktor beträgt bei der Abscheidung 350°C. Bei der Abscheidung werden das erste Gegenelektrodenelement 151 und das zweite Gegenelektrodenelement 152 unabhängig voneinander angesteuert.

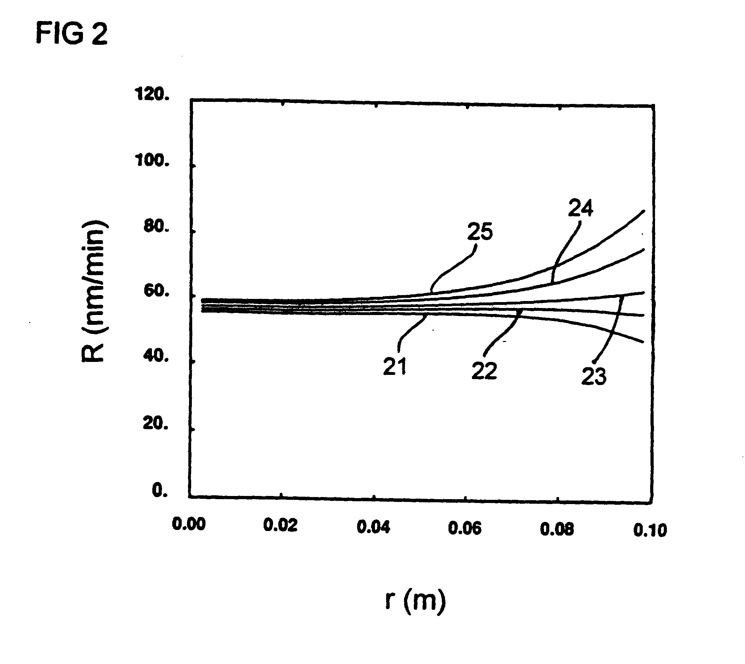

Figur 2 zeigt das Ergebnis einer Simulationsrechnung für das Beispiel der amorphen Siliziumabscheidung für die Abscheiderate R in Abhängigkeit des radialen Abstandes r. Die an das erste Gegenelektrodenelement angelegte Spannung beträgt jeweils 100 Volt, während die Spannung an dem zweiten Gegenelektrodenelement 152 zwischen 60 und 160 Volt variiert. Im einzelnen gelten folgende Werte:

| Kurve | Spannung am ersten Gegenelektro-denelement 151 | Spannung am zweiten Gegenelektrodenelement 152 | Hochfrequenz |
|---|---|---|---|
| 21 | 100 Volt | 60 Volt | 13,56 MHz |
| 22 | 100 Volt | 80 Volt | 13,56 MHz |
| 23 | 100 Volt | 100 Volt | 13,56 MHz |
| 24 | 100 Volt | 125 Volt | 13,56 MHz |
| 25 | 100 Volt | 150 Volt | 13,56 MHz |

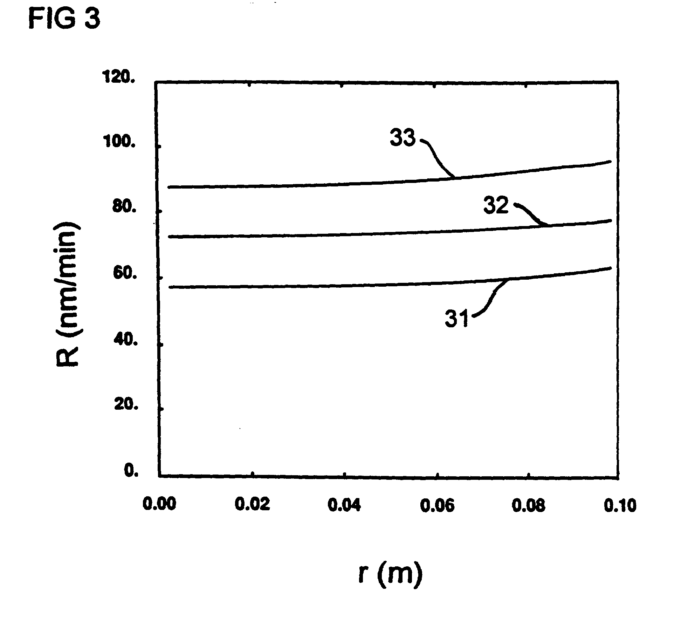

Figur 3 zeigt das entsprechende Ergebnis einer Simulationsrechnung für die Abscheidung vom amorphem Silizium für die Abscheiderate R als Funktion des radialen Abstands r vom Mittelpunkt. Dabei ist die an das erste Gegenelektrodenelement 151 angelegte Spannung variiert worden, während die an das zweite Gegenelektrodenelement 152 angelegte Spannung fest ist. Im einzelnen gilt:

| Kurve | Spannung am ersten Gegenelektro-denelement 151 | Spannung am zweiten Gegenelektrodenelement 152 | Hochfrequenz |
|---|---|---|---|
| 31 | 100 Volt | 100 Volt | 13,56 MHz |
| 32 | 125 Volt | 100 Volt | 13,56 MHz |
| 33 | 150 Volt | 100 Volt | 13,56 MHz |

Diese Simulationsrechnungen zeigen, daß die absolute Abscheiderate in dem erfindungsgemäßen Plasmareaktor durch die Ansteuerung des ersten Gegenelektrodenelementes 151 bestimmt wird, während die Homogenität der Abscheidung durch die Ansteuerung des zweiten Gegenelektrodenelementes, das ringförmig ist, beeinflußt wird.

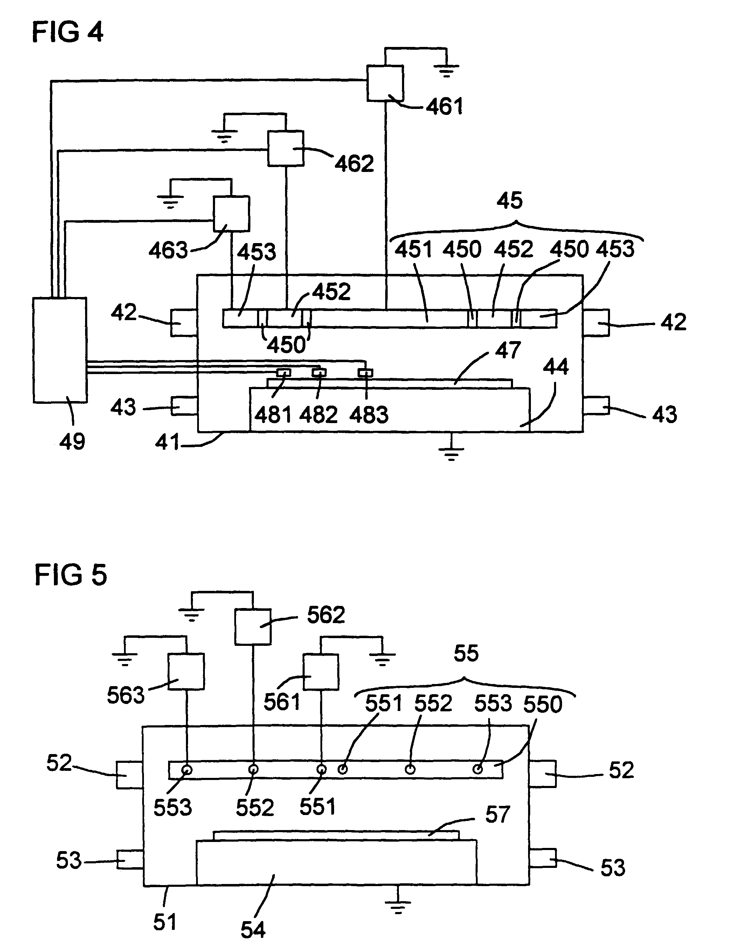

Gemäß einem weiteren Ausführungsbeispiel umfaßt ein Plasmareaktor eine Reaktionskammer 41, die mit Pumpstutzen 42 und Gaszuführungen 43 zum Einlaß von Prozeßgasen versehen ist (siehe Figur 4). Die Reaktionskammer 41 ist mit einem Bezugspotential, zum Beispiel Erde, verbunden.

In der Reaktionskammer 41 ist ein Scheibenhalter 44 vorgesehen, der ebenfalls mit dem Bezugspotential verbunden ist. Der Scheibenhalter 44 ist zum Beispiel zylinderförmig und weist einen Durchmesser von 200 mm auf. Im Betrieb des Plasmareaktors wird der Scheibenhalter 44 als eine Elektrode, die mit Bezugspotential verbunden ist, verwendet.

Dem Scheibenhalter 44 gegenüber ist eine Gegenelektrodenanordnung 45 angeordnet. Sie umfaßt ein erstes Gegenelektrodenelement 451, ein zweites Gegenelektrodenelement 452 und ein drittes Gegenelektrodenelement 453. Alle drei Gegenelektrodenelemente 451, 452, 453 sind in einer Ebene angeordnet. Das erste Gegenelektrodenelement ist kreisförmig und weist einen Durchmesser von zum Beispiel 100 mm auf. Das zweite Gegenelektrodenelement ist ringförmig und weist einen Außendurchmesser von zum Beispiel 200 mm auf. Das dritte Gegenelektrodenelement 453 ist auch ringförmig mit einem Außendurchmesser von zum Beispiel 250 mm. Zwischen dem ersten Gegenelektrodenelement 451 und dem zweiten Gegenelektrodenelement 452 sowie zwischen dem zweiten Gegenelektrodenelement 452 und dem dritten Gegenelektrodenelement 453 ist jeweils ein Spalt 450 mit einer Weite von 2 mm vorgesehen. Zwischen der Gegenelektrodenanordnung 45 und dem Scheibenhalter 44 beträgt der Abstand 80 mm.

Jedes der Gegenelektrodenelemente 451, 452, 453 ist kapazitiv mit einer Hochfrequenzspannungsquelle 461, 462, 463 verbunden, die jeweils unabhängig voneinander ansteuerbar sind. Über die Hochspannungsquellen 461, 462, 463 werden die Gegenelektrodenelemente 451, 452, 453 unabhängig voneinander angesteuert.

In der Reaktionskammer 41 sind Meßeinrichtungen 481, 482, 483 vorgesehen, die auf zum Beispiel drei Punkte der Oberflache einer Substratscheibe 47 gerichtet sind, die im Betrieb des Plasmareaktors auf dem Scheibenhalter 44 angeordnet ist. Die Meßeinrichtungen 481, 482, 483 messen eine Größe, die dem Prozeß im Plasmareaktor unterworfen ist. Wird der Plasmareaktor zum Ätzen verwendet, so werden über die Meßeinrichtungen 481, 482, 483 jeweils die verbliebene Schichtdicke an den Meßpunkten registriert. Wird im Plasmareaktor dagegen eine Abscheidung durchgeführt, so wird die aktuelle Schichtdicke an den Meßpunkten registriert. Dazu sind die Meßeinrichtungen 481, 482, 483 zum Beispiel als Schwingquarz oder Ellipsometer ausgebildet.

Die Meßeinrichtungen 481, 482, 483 weisen Ausgänge auf, die mit Eingängen einer Steuereinheit 49 verbunden sind. Die Steuereinheit 49 weist darüber hinaus Ausgänge auf, die jeweils mit einem Steuereingang der Hochfrequenzspannungsquellen 461, 462, 463 verbunden sind. Die Steuereinheit 49 umfaßt zum Beispiel einen Mikroprozessor, in dem eine Auswertung der von den Meßeinrichtungen 481, 482, 483 aufgenommenen Daten erfolgt. Abhängig von dieser Auswertung werden auf die Hochfrequenzspannungsquellen 461, 462, 463 Steuersignale gegeben, die zu einer sofortigen Nachstellung der Elektrodenansteuerung führen.

Der anhand von Figur 4 erläuterte Plasmareaktor kann zum Beispiel zum Ätzen von Polysilizium verwendet werden. Dazu wird folgendes Prozeßgas Cl₂ mit einer Durchflußrate 70 sccm (Standard-Kubikzentimeter pro Minute) verwendet. Der Druck im Plasmareaktor beträgt 16 Pa (120 mTorr), die Temperatur 300 K. An die Gegenelektrodenanordnung 45 werden folgende Leistungen angekoppelt:

| | |
|---|---|
| erstes Gegenelektrodenelement 451 | 200 W |
| zweites Gegenelektrodenelement 452 | 250 W |
| drittes Gegenelektrodenelement 453 | 300 W |

Die Wechselspannung weist jeweils eine Hochfrequenz von 13,56 MHz auf.

In einem weiteren Ausführungsbeispiel umfaßt ein Plasmareaktor eine Reaktionskammer 51, die mit Pumpstutzen 52 und Gaszuführungen 53 für ein Prozeßgas versehen ist (siehe Figur 5). Die Reaktionskammer 51 ist mit einem Bezugspotential, zum Beispiel Nullpotential, verbunden.

In der Reaktionskammer 51 ist ein Scheibenhalter 54 angeordnet, der zur Aufnahme von Substratscheiben 57 mit einem Durchmesser bis zu 200 mm geeignet ist. Der Scheibenhalter 54 ist ebenfalls mit dem Bezugspotential verbunden.

In der Reaktionskammer ist eine Antennenanordnung 55 vorgesehen. Die Antennenanordnung 55 umfaßt voneinander unabhängige Antennen 551, 552, 553, die in einer Isolationsstruktur 550 aus zum Beispiel Quarz eingebettet sind. Jede der Antennen 551, 552, 553 ist mit einer Wechselstromquelle 561, 562, 563 verbunden. Die Antennen 551, 552, 553 sind jeweils im wesentlichen ringförmig ausgebildet und konzentrisch in einer Ebene angeordnet. Die erste Antenne 551 weist dabei einen Durchmesser von zum Beispiel 100 mm, die zweite Antenne 552 weist einen Durchmesser von zum Beispiel 200 mm, die dritte Antenne 553 weist einen Durchmesser von zum Beispiel 250 mm auf.

Im Betrieb des Plasmareaktors wird über die Antennenanordnung 55 induktiv ein Plasma zwischen der Antennenanordnung 55 und der Substratscheibe 57 angeregt. Da die Antennen 551, 552, 553 unabhängig voneinander über die Wechselstromquellen 561, 562, 563 angesteuert werden, wird das Plasma an unterschiedlichen Orten oberhalb der Substratscheibe 57 unterschiedlich angeregt. Dadurch werden homogene Reaktionsraten über die gesamte Substratscheibe 57 realisiert.

Der anhand von Figur 5 erläuterte Plasmareaktor entspricht einem ICP-Reaktor. Er ist sowohl zum Ätzen als auch zum Schichtabscheiden geeignet.

In diesem Plasmareaktor wird zum Beispiel Polysilizium geätzt. Dazu wird folgendes Prozeßgas Cl₂ mit einer Durchflußrate von 200 sccm verwendet. Der Druck in der Reaktionskammer 51 beträgt 1,33 Pa (10 mTorr), die Temperatur 300 K. Die Antennen 551, 552, 553 werden mit folgenden elektrischen Daten angesteuert:

| | |
|---|---|
| Antenne 551 | 1 kW |
| Antenne 552 | 1,2 kW |
| Antenne 553 | 1,4 kW |

## Patentansprüche

1. Plasmareaktor
- mit einem Scheibenhalter (14), der mit einem Bezugspotential verbunden ist,
- mit Pumpstutzen (12),
- mit Gaszuführungen (13),
- mit einer geerdeten Elektrode,
- mit einer Einrichtung (15) zur Plasmaanregung durch Einkopplung elektrischer Energie, die mindestens zwei unabhängig voneinander ansteuerbare Teileinrichtungen (151, 152) umfaßt, über die das Plasma an mindestens zwei verschiedenen Orten über dem Scheibenhalter (14) unterschiedlich anregbar ist,
- bei dem die Einrichtung zur Plasmaanregung mindestens eine mit einem Bezugspotential verbundene Elektrode (14) und eine Gegenelektrodenanordnung (15) umfaßt, wobei die Gegenelektrodenanordnung (15) mindestens zwei voneinander unabhängig ansteuerbare Gegenelektrodenelemente (151, 152) umfaßt,
- bei dem der Scheibenhalter (14) zwichen der geerdeten Elektrode und der Gegenelektrodenanordnung (15) angeordnet ist,
dadurch gekennzeichnet, daß
- die Einrichtung zur Plasmaanregung darüber hinaus mindestens zwei Hochfrequenzspannungsquellen (161, 162) umfaßt, die jeweils mit einem der Gegenelektrodenelemente (151, 152) kapazitiv verbunden sind.

2. Plasmareaktor nach Anspruch 1,
- bei dem eines der Gegenelektrodenelemente (151) kreisförmig ausgebildet ist und mindestens eines der weiteren Gegenelektrodenelemente (152) ringförmig ausgebildet ist und
- bei dem das kreisförmige Gegenelektrodenelement (151) und das ringförmige Gegenelektrodenelement (152) konzentrisch in einer Ebene angeordnet sind.

3. Plasmareaktor
- mit einem Scheibenhalter (14), der mit einem Bezugspotential verbunden ist,
- mit Pumpstutzen (12),
- mit Gaszuführungen (13),
- mit einer Einrichtung (15) zur Plasmaanregung durch Einkopplung elektrischer Energie, die mindestens zwei unabhängig voneinander ansteuerbare Teileinrichtungen (151, 152) umfaßt, über die das Plasma an mindestens zwei verschiedenen Orten über dem Scheibenhalter (14) unterschiedlich an regbar ist,
dadurch gekennzeichnet, daß
- die Einrichtung zur Plasmaanregung einer Antennenanordnung (55) mit mindestens zwei Antennen (551, 552, 553) umfaßt, über die elektrische Energie zur Plasmaanregung induktiv eingekoppelt wird,
- die Einrichtung darüber hinaus mindestens zwei Wechselstromquelle (561, 562, 563) umfaßt, die jeweils mit einer der Antennen (551, 552, 553) verbunden sind,
- die Antennen (551, 552, 553) jeweils im wesentlichen ringförmig mit unterschiedlichem Radius ausgebildet sind und konzentrisch in einer Ebene angeordnet sind.

4. Plasmareaktor nach einem der Ansprüche 1 bis 3,
- bei dem Mittel (481, 482, 483) zur Bewertung eines im Plasmareaktor ablaufenden Prozesses durch Messung einer dem Prozeß unterworfenen Größe an mehreren Orten eines auf dem Scheibenhalter (44) angeordneten Substrats (47) vorgesehen sind,
- bei dem Mittel (49) zur Ansteuerung der Teileinrichtungen (451, 452, 453) in Abhängigkeit der Messung vorgesehen sind.

5. Verfahren zum Betrieb eines Plasmareaktors nach einem der Ansprüche 1 bis 4,
bei dem die Teileinrichtungen zur Plasmaanregung unterschiedlich angesteuert werden.

6. Verfahren nach Anspruch 5,
- bei dem während eines im Plasmareaktor ablaufenden Prozesses eine dem Prozeß unterworfene Größe an mehreren Orten eines auf dem Scheibenhalter angeordneten Substrates gemessen wird und
- bei dem die Teileinrichtungen zur Plasmaanregung in Abhängigkeit der gemessenen Größe angesteuert werden.

7. Verfahren nach Anspruch 6,
bei dem durch Vergleich der gemessenen Größe mit dem entsprechenden Wert einer numerischen Simulation des Plasmareaktors iterativ Parameter zur Ansteuerung der Teileinrichtungen zur Plasmaanregung bestimmt werden.

## Claims

1. Plasma reactor
- having a wafer holder (14), which is connected to a reference potential,
- having pump connecting pieces (12),
- having gas feed lines (13),
- have an earthed electrode,
- having an equipment (15) for exciting the plasma by injecting electrical energy, which comprises at least two subequipments (151, 152) which can be driven independently of one another, via which the plasma can be excited differently at at least two different locations above the wafer holder (14),
- in which the equipment for exciting the plasma comprises at least one electrode (14), connected to a reference potential, and a mating electrode arrangement (15), the mating electrode arrangement (15) comprising at least two mating electrode elements (151, 152) which can be driven independently of one another,
- in which the wafer holder (14) is arranged between the earthed electrode and the mating electrode arrangement (15),
characterized in that
- the equipment for exciting the plasma furthermore comprises at least two high-frequency voltage sources (161, 162), which in each case are capacitively connected to one of the mating electrode elements (151, 152).

2. Plasma reactor according to Claim 1,
- in which one of the mating electrode elements (151) is of circular design and at least one of the further mating electrode elements (152) is of annular design and
- in which the circular mating electrode element (151) and the annular mating electrode element (152) are arranged concentrically in one plane.

3. Plasma reactor
- having a wafer holder (14), which is connected to a reference potential,
- having pump connecting pieces (12),
- having gas feed lines (13),
- having an equipment (15) for exciting the plasma by injecting electrical energy, which comprises at least two subequipments (151, 152) which can be driven independently of one another, via which the plasma can be excited differently at at least two different locations above the wafer holder (14),
characterized in that
- the equipment for exciting the plasma comprises an antenna arrangement (55) having at least two antennas (551, 552, 553), via which electrical energy is inductively injected to excite the plasma, - the equipment furthermore comprises at least two alternating current sources (561, 562, 563) which are in each case connected to one of the antennas (551, 552, 553),
- the antennas (551, 552, 553) are in each case of essentially annular design with a different radius and are arranged concentrically in one plane.

4. Plasma reactor according to one of Claims 1 to 3,
- in which means (481, 482, 483) are provided for assessing a process which is proceeding in the plasma reactor by measuring a variable which is subjected to the process at a plurality of locations on a substrate (47) arranged on the wafer holder (44),
- in which means (49) are provided for driving the subequipments (451, 452, 453) as a function of the measurement.

5. Method for operating a plasma reactor according to one of Claims 1 to 4,
in which the subequipments for exciting the plasma are driven differently.

6. Method according to Claim 5,
- in which, during a process which is proceeding in the plasma reactor, a variable which is subjected to the process is measured at a plurality of locations on a substrate arranged on the wafer holder, and
- in which the subequipments for exciting the plasma are driven as a function of the measured variable.

7. Method according to Claim 6,
in which, by comparing the measured variable with the corresponding value of a numerical simulation of the plasma reactor, parameters for driving the subequipments for exciting the plasma are determined iteratively.

## Revendications

1. Réacteur au plasma
- comprenant un support de plaquette (14) relié à un potentiel de référence,
- comprenant des tubulures de pompage (12),
- comprenant des alimentations en gaz (13),
- comprenant une électrode mise à la terre,
- comprenant un dispositif (15) permettant l'excitation du plasma par apport d'énergie électrique, composé d'au moins deux dispositifs partiels (151, 152) susceptibles d'être mis sous tension indépendamment l'un de l'autre, par l'intermédiaire desquels le plasma peut être excité de manière différente à au moins deux endroits différents au-dessus du support de plaquette (14),
- dans lequel le dispositif d'excitation du plasma comprend au moins une électrode (14) reliée à un potentiel de référence et un agencement de contre-électrodes (15), ledit agencement de contre-électrodes (15) comprenant au moins deux contre-électrodes (151, 152) susceptibles d'être mises sous tension indépendamment l'une de l'autre,
- dans lequel le support de plaquette (14) est disposé entre l'électrode mise à la terre et l'agencement de contre-électrodes (15),
caractérisé en ce que le dispositif d'excitation du plasma comprend en outre au moins deux sources de tension haute fréquence (161, 162) reliées chacune de manière capacitive à l'une des contre-électrodes (151, 152).

2. Réacteur au plasma selon la revendication 1,
- dans lequel l'une des contre-électrodes (151) est de forme circulaire et au moins l'une des autres contre-électrodes (152) de forme annulaire, et
- dans lequel la contre-électrode circulaire (151) et la contre-électrode annulaire (152) sont disposées concentriquement dans un même plan.

3. Réacteur au plasma
- comprenant un support de plaquette (14) relié à un potentiel de référence,
- comprenant des tubulures de pompage (12),
- comprenant des alimentations en gaz (13),
- comprenant un dispositif (15) permettant l'excitation du plasma par apport d'énergie électrique, composé d'au moins deux dispositifs partiels (151, 152) susceptibles d'être mis sous tension indépendamment l'un de l'autre, par l'intermédiaire desquels le plasma peut être excité de manière différente à au moins deux endroits différents au-dessus du support de plaquette (14),
caractérisé en ce que
- le dispositif d'excitation du plasma comprend un agencement d'antennes (55) pourvu d'au moins deux antennes (551, 552, 553), qui assurent de manière inductive l'apport d'énergie électrique pour exciter le plasma,
- le dispositif comprend en outre au moins deux sources de courant alternatif (561, 562, 563) reliées chacune à l'une des antennes (551, 552, 553),
- les antennes (551, 552, 553) sont chacune conçues de forme essentiellement annulaire de rayon différent et disposées concentriquement dans un même plan.

4. Réacteur au plasma selon l'une des revendications 1 à 3,
- dans lequel sont prévus des moyens (481, 482, 483) permettant l'évaluation d'un processus se déroulant dans le réacteur au plasma, en mesurant une grandeur soumise au processus, à plusieurs endroits d'un substrat (47) placé sur le support de plaquette (44),
- dans lequel sont prévus des moyens (49) permettant la mise sous tension des dispositifs partiels (451, 452, 453), en fonction de la mesure.

5. Procédé permettant le fonctionnement d'un réacteur au plasma défini selon l'une des revendications 1 à 4, dans lequel les dispositifs partiels d'excitation du plasma sont mis sous tension de manière différente.

6. Procédé selon la revendication 5,
- dans lequel, au cours d'un processus se déroulant dans le réacteur au plasma, une grandeur soumise au processus est mesurée à plusieurs endroits d'un substrat placé sur le support de plaquette, et
- dans lequel les dispositifs partiels d'excitation du plasma sont mis sous tension en fonction de la grandeur mesurée.

7. Procédé selon la revendication 6, dans lequel, en comparant la grandeur mesurée avec la valeur correspondante d'une simulation numérique du réacteur au plasma, les paramètres permettant la mise sous tension des dispositifs partiels d'excitation du plasma sont définis de manière itérative.
